# EUROPEAN PATENT SPECIFICATION

(11) **EP 4 633 052 B1**
(45) Date of publication and mention of the grant of the patent: **30.09.2026**
(21) Application number: 24759636.4
(22) Date of filing: 19.02.2024
(51) Int. Cl.: H04B 7/06, H03M 7/30, G06N 10/60

(54) **PHASE ENCODING METHOD AND APPARATUS, AND COMMUNICATION DEVICE**
PHASENCODIERUNGSVERFAHREN UND -VORRICHTUNG SOWIE KOMMUNIKATIONSVORRICHTUNG
PROCÉDÉ ET APPAREIL DE CODAGE DE PHASE, ET DISPOSITIF DE COMMUNICATION

(30) Priority: 20.02.2023 CN 202310184040
(43) Date of publication of application: 15.10.2025
(73) Proprietor: Huawei Technologies Co., Ltd., Shenzhen, Guangdong 518129 (CN)
(72) Inventor: WANG, Biying, Shenzhen, Guangdong 518129 (CN); CUI, Xiaopeng, Shenzhen, Guangdong 518129 (CN); XU, Hongjing, Shenzhen, Guangdong 518129 (CN); ZHANG, Guanxi, Shenzhen, Guangdong 518129 (CN); YUNG, Man Hong, Shenzhen, Guangdong 518129 (CN)
(74) Representative: Maiwald GmbH
(86) International application number: PCT/CN2024/077546
(87) International publication number: WO 2024/174959

(56) References cited:
- WO-A1-2023/009217
- CN-A- 107 534 633
- CN-A- 110 988 816
- CN-A- 113 098 811
- JP-A- 2019 036 940
- US-A1- 2013 058 431
- US-A1- 2020 220 598
- ZENG QING-GUO ET AL: "High-order-modulation large MIMO detector based on physics-inspired methods", PHYSICAL REVIEW APPLIED, vol. 24, no. 3, 18 August 2025 (2025-08-18), XP093366223, ISSN: 2331-7019, DOI: 10.1103/zmgv-m2ql
- YUTONG JIANG ET AL: "Quantum-inspired Beamforming Optimization for Quantized Phase-only Massive MIMO Arrays", ARXIV.ORG, CORNELL UNIVERSITY LIBRARY, 201 OLIN LIBRARY CORNELL UNIVERSITY ITHACA, NY 14853, 28 May 2025 (2025-05-28), XP092041288

## Description

### TECHNICAL FIELD

Embodiments of this application relate to the field of communication technologies, and in particular, to a phase encoding method and apparatus, and a communication device.

### BACKGROUND

Rapid development of wireless communication technologies leads to an increasing shortage of spectrum resources. As a key technology of current 5th generation (5th generation, 5G) mobile communication and next generation mobile communication, a massive multiple-input multiple-output (massive multiple-input multiple-output, Massive MIMO) system can greatly improve spectrum utilization by using a space division technology.

For an antenna array in massive MIMO, a plurality of antenna elements may be arranged, and then beamforming is implemented through weight optimization. In a multi-antenna scenario, a spatial electric field is obtained through superposition on radiation fields of antennas based on phase coherence. Due to interference and diffraction characteristics of waves, after signals with different amplitudes and phases that are transmitted by different antennas are superposed, energy in some directions increases, and energy in some directions decreases. In a multi-antenna communication process, a beamforming process may be intervened based on a characteristic that an electromagnetic wave radiates into a beam with a narrow width in a specific direction. In other words, a transmit signal of each antenna is weighted based on a requirement, and an amplitude or a phase of the transmit signal of each antenna is changed purposefully, so that a finally formed beam has an exact width and orientation needed for actual communication. This process is beamforming.

A key to beamforming is to use an optimization algorithm to perform weight optimization. When some optimization algorithms are used, a phase needs to be encoded, and an encoding mode may directly affect solution quality of the algorithm. As an antenna scale grows from hundreds to thousands, a large quantity of redundant codes are generated when various methods in the conventional technology are used to perform phase encoding, severely affecting a speed and quality of weight optimization.

Document US2020/220598A1 discloses a phase encoding method in the same context.

Document WO 2023/009217A1 discloses a method for reducing distortion in wireless communication system using first-order terms and higher-order terms of the corresponding input signals.

### SUMMARY

Embodiments of this application provide a phase encoding method and apparatus, and a communication device, to resolve a problem in the conventional technology that a large quantity of redundant codes are generated during phase encoding, severely affecting a speed and quality of weight optimization.

To achieve the foregoing objective, the following technical solutions are used in this application.

A first aspect of embodiments of this application provides a phase encoding method, including:
determining, based on a plurality of to-be-encoded phases, a quantity of a plurality of bits needed for encoding the plurality of phases;
generating first-order terms and higher-order terms of the plurality of bits;
constructing a bit matrix based on the plurality of phases, the first-order terms, and the higher-order terms, where the bit matrix includes a plurality of value combinations of the plurality of bits;
calculating a plurality of encoding coefficients based on the bit matrix and the plurality of phases; and
encoding the plurality of phases by using the plurality of encoding coefficients.

In comparison with conventional technologies, beneficial effects of the phase encoding method provided in this embodiment of this application include: In this embodiment of this application, a higher-order term is introduced to construct encoding, so that a coefficient matrix of a system of linear equations that needs to be solved is a full-rank square matrix, and one-to-one encoding for *N* bits to 2*^{N}* phases is implemented. In the method, a large quantity of redundant codes are not generated in an encoding process. This is beneficial to optimization of a subsequent optimization algorithm. In addition, in the phase encoding method provided in this embodiment of this application, a quantity of bits needed for encoding can be reduced as much as possible. In comparison with conventional technologies in which only phase encoding is performed by using a QAM encoding mode, the quantity of bits can be halved.

It should be understood that the phase encoding method provided in this embodiment of this application may be applied to a plurality of scenarios. The plurality of scenarios may include a communication scenario or a non-communication scenario. For example, in a communication scenario, the method may be used to encode a phase of a discrete signal. In a non-communication scenario, if an object that needs to be encoded is a discrete value, the method may also be used for encoding.

In an example of the first aspect, when a quantity of the plurality of phases is 2*^{N}*, the quantity of bits needed for encoding the 2*^{N}* phases is *N.*

In a possible implementation of the first aspect, generating the first-order terms and the higher-order terms of the plurality of bits may include: generating a first-order term of each bit; and multiplying the bits one by one to obtain the higher-order terms including a second-order product term to an *N*-order product term. The first-order term may be the bit, *N* is the quantity of the plurality of bits, a higher-order term of any order may include a product term of the plurality of bits, and bits in a same product term are different from each other.

It should be understood that, when the first-order terms and the higher-order terms of the plurality of bits are generated, all first-order terms and higher-order terms of the plurality of bits may be generated.

In a possible implementation of the first aspect, multiplying the bits one by one to obtain the higher-order terms including the second-order product term to the *N*-order product term includes: determining an order of a to-be-generated higher-order term; determining a quantity of higher-order terms with the order; and multiplying the bits one by one based on the quantity of terms to obtain the higher-order terms with the order.

For example, when the higher-order terms of the plurality of bits are generated, an order, for example, a third order, a fourth order, or a fifth order, of a currently to-be-generated higher-order term may be first determined. Then, for a corresponding order, a quantity of higher-order terms corresponding to the order is determined, and then all higher-order terms with the order are obtained by multiplying the bits one by one. In this way, it can be ensured that all higher-order terms are generated without omission.

In an example of the first aspect, when a quantity of the plurality of bits is *N* and the order is *X*, the quantity of higher-order terms with the order is ${C}_{N}^{X}$.

In a possible implementation of the first aspect, constructing the bit matrix based on the plurality of phases, the first-order terms, and the higher-order terms includes: constructing a system of linear equations based on the plurality of phases, the first-order terms, and the higher-order terms; and determining the bit matrix based on the system of linear equations.

A quantity of equations included in the system of linear equations is equal to the quantity of the plurality of phases, expressions of the phases on one side of equal signs of the plurality of equations are different from each other, expressions of the first-order terms and the higher-order terms on the other side of the equal signs of the plurality of equations are the same, the first-order term and the higher-order term in each equation have coefficients respectively, and the coefficients form the encoding coefficients.

In another possible implementation of the first aspect, if rotation angles of the plurality of to-be-encoded phases are equally spaced, a half of the phases may be obtained by rotating the other half of the phases by 180°, that is, the other half of the phases may be obtained by multiplying the half of the phases by -1. Therefore, when the rotation angles of the plurality of phases are equally spaced, a simplified calculation method may be used in a process of generating higher-order terms, and only higher-order terms of odd-numbered terms are extracted. The system of linear equations is then constructed based on the plurality of phases, the first-order terms, and the extracted higher-order terms of the odd-numbered terms.

In another possible implementation of the first aspect, when the bit matrix is determined based on the system of linear equations, a value of any bit may be first determined; and then values of other bits are generated based on the value of the any bit, to obtain the plurality of value combinations of the plurality of bits, where the plurality of value combinations form the bit matrix.

In an example of the first aspect, the values of the any bit and the other bits may be 1 or -1.

For example, it may be first determined that the value of the any bit is 1, and then a value of each of the other bits is determined. The value of each of the other bits needs to meet the foregoing requirement, to be specific, the value of each of the other bits also needs to be 1 or -1. Alternatively, it may be first determined that the value of the any bit is -1, and then a value of each of the other bits is determined as 1 or -1.

In a possible implementation of the first aspect, calculating the plurality of encoding coefficients based on the bit matrix and the plurality of phases includes: determining a phase vector including the plurality of phases; calculating a product of a transpose of the phase vector and an inverse matrix of the bit matrix, to obtain a transpose of a coefficient vector including the plurality of encoding coefficients; and determining the plurality of encoding coefficients based on the transpose of the coefficient vector.

In a possible implementation of the first aspect, the system of linear equations may be represented in a form of matrix calculation, that is, ${S}_{N} {C}^{T} = {P}^{T}$

*S_{N}* is the bit matrix, a vector C=[*c*₁, ..., *c*_{2*_{N}*}], the vector C is a coefficient vector including the plurality of encoding coefficients, a vector P is a phase vector including the plurality of to-be-encoded phases, and *C^{T}* and *P^{T}* are respectively transposes of the coefficient vector C and the phase vector P.

Through matrix calculation, an expression of the encoding coefficient may be obtained through calculation as: ${C}^{T} = {{S}_{N}}^{- 1} {P}^{T}$

*S_{N}*⁻¹ is the inverse matrix of the bit matrix *S_{N}*.

A second aspect of embodiments of this application provides a phase encoding apparatus. The apparatus may include the following modules: a determining module, a generation module, a construction module, a calculation module, and an encoding module.

The determining module is configured to determine, based on a plurality of to-be-encoded phases, a quantity of a plurality of bits needed for encoding the plurality of phases.

The generation module is configured to generate first-order terms and higher-order terms of the plurality of bits.

The construction module is configured to construct a bit matrix based on the plurality of phases, the first-order terms, and the higher-order terms, where the bit matrix includes a plurality of value combinations of the plurality of bits.

The calculation module is configured to calculate a plurality of encoding coefficients based on the bit matrix and the plurality of phases.

The encoding module encodes the plurality of phases by using the plurality of encoding coefficients.

In an example of the second aspect, when a quantity of the plurality of phases is 2*^{N},* the quantity of bits needed for encoding the 2*^{N}* phases is *N.*

In a possible implementation of the second aspect, the generation module may be specifically configured to:
generate a first-order term of each bit, where the first-order term may be the bit; and
multiply the bits one by one to obtain the higher-order terms including a second-order product term to an N-order product term, where N is a quantity of the plurality of bits, a higher-order term of any order may include product terms of the plurality of bits, and bits in a same product term are different from each other.

When generating the higher-order term, the generation module may be further configured to: determine an order of a to-be-generated higher-order term; determine a quantity of higher-order terms with the order; and multiply the bits one by one based on the quantity of terms to obtain the higher-order terms with the order.

In an example of the second aspect, when a quantity of the plurality of bits is *N* and the order is *X,* the quantity of higher-order terms with the order is ${C}_{N}^{X}$.

In a possible implementation of the second aspect, the construction module may be specifically configured to: construct a system of linear equations based on the plurality of phases, the first-order terms, and the higher-order terms; and determine the bit matrix based on the system of linear equations.

A quantity of equations included in the system of linear equations is equal to the quantity of the plurality of phases, expressions of the phases on one side of equal signs of the plurality of equations are different from each other, expressions of the first-order terms and the higher-order terms on the other side of the equal signs of the plurality of equations are the same, the first-order term and the higher-order term in each equation have coefficients respectively, and the coefficients form the encoding coefficients.

In another possible implementation of the second aspect, the construction module may be further configured to: if rotation angles of the plurality of phases are equally spaced, extract the higher-order terms of odd-numbered terms; and construct the system of linear equations based on the plurality of phases, the first-order terms, and the higher-order terms of the odd-numbered terms.

In still another possible implementation of the second aspect, the construction module may be further configured to: determine a value of any bit; and generate values of other bits based on the value of the any bit, to obtain the plurality of value combinations of the plurality of bits, where the plurality of value combinations form the bit matrix.

In an example of the second aspect, the values of the any bit and the other bits may be 1 or -1.

In a possible implementation of the second aspect, the calculation module may be specifically configured to: determine a phase vector including the plurality of phases; calculate a product of a transpose of the phase vector and an inverse matrix of the bit matrix, to obtain a transpose of a coefficient vector including the plurality of encoding coefficients; and determine the plurality of encoding coefficients based on the transpose of the coefficient vector.

The system of linear equations may be represented in a form of matrix calculation, that is, ${S}_{N} {C}^{T} = {P}^{T}$

*S_{N}* is the bit matrix, a vector C=[*c*₁, *..., c*_{2*_{N}*}], the vector C is a coefficient vector including the plurality of encoding coefficients, a vector P is a phase vector including the plurality of to-be-encoded phases, and *C^{T}* and *P^{T}* are respectively transposes of the coefficient vector C and the phase vector P.

Through matrix calculation, an expression of the encoding coefficient may be obtained through calculation as: ${C}^{T} = {{S}_{N}}^{- 1} {P}^{T}$

*S_{N}*⁻¹ is the inverse matrix of the bit matrix *S_{N}*.

A third aspect of embodiments of this application provides a communication device, including a memory, a processor, and a computer program that is stored in the memory and that is executable on the processor. When executing the computer program, the processor implements the phase encoding method according to any one of the implementations of the first aspect.

It should be understood that the communication device may include any one of a base station, an intelligent reflecting surface, or a router.

A fourth aspect of embodiments of this application provides a computer-readable storage medium. The computer-readable storage medium stores computer instructions, and when the computer instructions are run on a computer device, the computer device is enabled to perform the foregoing related method steps to implement the phase encoding method according to any one of the implementations of the first aspect. The computer device may include but is not limited to a communication device.

A fifth aspect of embodiments of this application provides a computer program product. When the computer program product runs on a computer device, the computer device performs the foregoing related steps, to implement the phase encoding method according to any one of the implementations of the first aspect.

A sixth aspect of embodiments of this application provides a chip. The chip includes a memory and a processor, and the processor executes a computer program stored in the memory, to implement the phase encoding method according to any one of the implementations of the first aspect.

It may be understood that, for beneficial effects of the second aspect to the sixth aspect, refer to related descriptions in the first aspect. Details are not described herein again.

### BRIEF DESCRIPTION OF DRAWINGS

FIG. 1 is a diagram of amplitude and phase encoding in the conventional technology;
FIG. 2 is a schematic flowchart of beamforming according to an embodiment of this application;
FIG. 3 is a diagram of a phase encoding method according to an embodiment of this application;
FIG. 4 is a diagram of phases of an antenna element according to an embodiment of this application;
FIG. 5 is a schematic flowchart of a phase encoding method according to an embodiment of this application;
FIG. 6 is a diagram of a system architecture of a base station according to an embodiment of this application;
FIG. 7 is a diagram of a system architecture of an intelligent reflecting surface according to an embodiment of this application;
FIG. 8 is a diagram of a beamforming result according to an embodiment of this application; and
FIG. 9 is a diagram of a phase encoding apparatus according to an embodiment of this application.

### DESCRIPTION OF EMBODIMENTS

To clearly describe technical solutions in embodiments of this application, terms such as "first" and "second" are used in embodiments of this application to distinguish between same items or similar items that provide basically same functions and purposes. For example, a first phase and a second phase are merely used to distinguish between different phases, and do not limit a quantity and an execution sequence of the first phase and the second phase.

It should be noted that, in embodiments of this application, terms such as "example" or "for example" are used to represent giving an example, an illustration, or a description. Any embodiment or design solution described by using "example" or "for example" in embodiments of this application should not be explained as being more preferred or having more advantages than another embodiment or design solution. Exactly, use of the terms such as "example" or "for example" is intended to present a related concept in a specific manner.

A service scenario described in embodiments of this application is intended to describe the technical solutions in embodiments of this application more clearly, but does not constitute a limitation on the technical solutions provided in embodiments of this application. A person of ordinary skill in the art may learn that as a new service scenario emerges, the technical solutions provided in embodiments of this application are also applicable to a similar technical problem.

In embodiments of this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one item (piece) of a, b, or c may indicate: a, b, c, a and b, a and c, b and c, or a, b, and c, where a, b, and c may be singular or plural.

Steps in a phase encoding method provided in embodiments of this application are merely examples. Not all steps are mandatory steps, or not all content in each step is mandatory. In a use process, addition or deletion may be performed as required.

A same step or steps or messages having a same function in embodiments of this application may be mutually referenced in different embodiments.

As an antenna scale grows from hundreds to thousands, phase optimization only in weight optimization can reduce communication costs better than amplitude and phase optimization, and has gradually become the focus of current research.

In algorithms for resolving a problem of weight optimization, a holographic algorithm is an algorithm having a high speed. This algorithm is an analytic algorithm, and resolves a problem of continuous optimization. However, in a real communication scenario, a limitation of a phase shifter in an antenna device makes antenna phases present a discrete characteristic. Using the holographic algorithm to transform results of continuous optimization to discrete values may introduce an extra error. As a result, an optimization effect is severely affected. Another algorithm to resolve the weight optimization problem is a genetic algorithm, which can resolve a unidirectional beam enhancement problem by perform selection, crossing, and mutation iteration on a population including all weight combinations. However, it often takes several days to optimize an array of thousands of antennas by using the genetic algorithm. As an antenna array scale grows, an optimization speed of the genetic algorithm cannot meet actual communication requirements. In addition, both the holographic algorithm and the genetic algorithm can only perform unidirectional beam enhancement, and cannot support multidirectional enhancement suppression in spatial domain. Currently, some researches begin to use quantum computing to resolve such optimization problems. Correspondingly, a classical algorithm inspired by quantum computing, that is, a quantum heuristic algorithm, is also now being studied, and becomes a potential algorithm that can quickly resolve any beamforming. However, whether quantum computing or the quantum heuristic algorithm is applied, the phases need to be encoded first, and an encoding mode directly affects solution quality of the optimization algorithm.

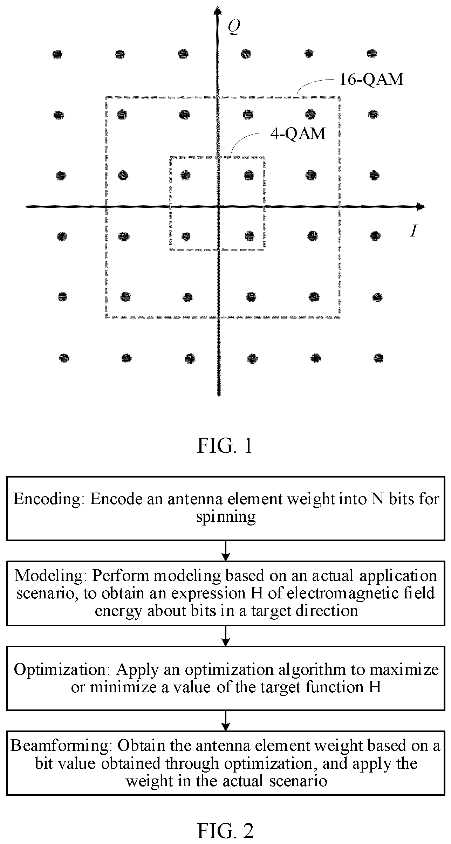

Amplitude and phase encoding (quadrature amplitude modulation, QAM) is a universal base station weight encoding method, and an encoding process thereof includes encoding for an antenna amplitude and a phase. FIG. 1 is a diagram of amplitude and phase encoding in the conventional technology. I represents a real part, Q represents an imaginary part, and any point in FIG. 1 represents a discrete signal. According to an encoding mode shown in FIG. 1, the real part I and the imaginary part Q need to be encoded at an equal spacing, and therefore, a base station weight satisfies: y=I+Qj. 16-QAM with 16 weights is used as an example. In the encoding mode, two bits are used to encode the real part, and two bits are used to encode the imaginary part. According to spacings ΔI and ΔQ in directions of the real part I and the imaginary part Q, overall encoding may be represented by the following Formula (1): $y = \left(\frac{ΔI}{2}{s}_{1}+\frac{3 ΔI}{2}{s}_{2}\right) + j \left(\frac{ΔQ}{2}{s}_{3}+\frac{3 ΔQ}{2}{s}_{4}\right)$

*s*₁ and *s*₂ represent the two bits for encoding the real part, and *s*₃ and *s*₄ represent the two bits for encoding the imaginary part.

Because in amplitude and phase encoding, the real part and the imaginary part are encoded separately, if the encoding mode is applied to only phase encoding, when a quantity of phases exceeds 4, a large quantity of redundant codes are generated. As a result, a quantity of bits needs to be increased additionally during weight optimization. In addition, the redundant codes generated during encoding based on the encoding mode may cause a large quantity of constraint items in an optimization process. This severely affects a speed and quality of optimization.

For the foregoing problem, an embodiment of this application provides a phase encoding method. The method is an encoding method in which *N* bits are mapped to 2*^{N}* phases, which means that an encoding scheme without redundancy or constraint is constructed with a minimum quantity of bits, to facilitate quick optimization of a subsequent algorithm and improve a capability of resolving a beamforming problem by using the algorithm.

FIG. 2 is a schematic flowchart of beamforming according to an embodiment of this application. According to a procedure shown in FIG. 2, a complete beamforming process usually includes four steps: encoding, modeling, optimization, and beamforming. In the encoding step, mapping of the *N* bits [*s*₁, ..., *s_{N}*] to an antenna element weight is completed, that is, the antenna element weight is encoded into the *N* bits for spinning. The weight herein is also a phase of an antenna element, and a value of each bit s may be ±1. After the encoding is completed, electromagnetic field energy in a specific direction in space may be calculated based on an actual application scenario, and modeling of a beamforming task is completed, to obtain an expression of electromagnetic field energy about bits in a target direction: *H*(*s*₁, ..., *s_{N}*). A modeling task may include beam enhancement or suppression, multi-beam multi-null, and the like, in a specific direction. Then, in the optimization step, an optimization algorithm may be applied to calculate a value of each bit, to maximize or minimize a value of the foregoing function H. An optimization algorithm that is actually applied may include quantum computing, a quantum heuristic algorithm, and the like. Finally, a weight of each antenna element in an antenna array may be determined based on the bit value obtained through optimization, and final beamforming may be completed by applying the weight to the actual application scenario. An application scenario in which beamforming is needed generally includes a base station, an intelligent reflecting surface (reconfigurable intelligent surface, RIS), a router, and the like. The phase encoding method provided in this embodiment of this application may be applied to the encoding step of the beamforming procedure shown in FIG. 2.

The following describes the phase encoding method in this application with reference to specific embodiments.

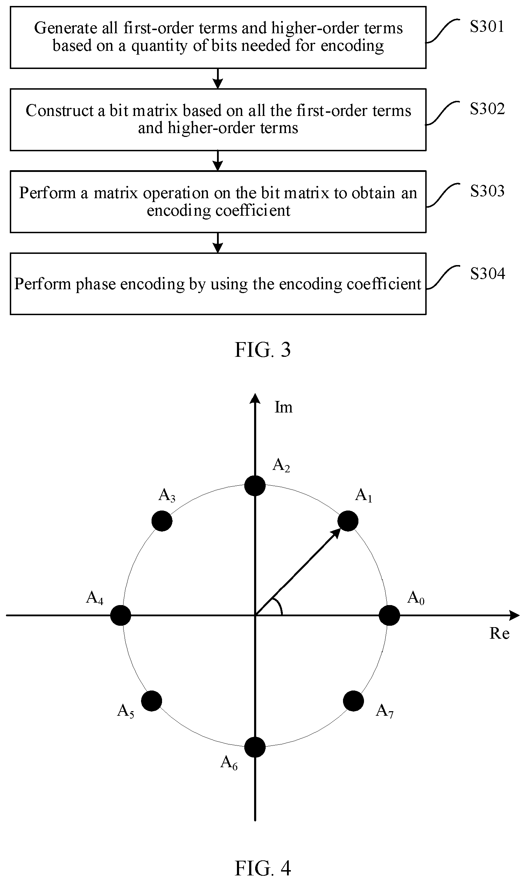

FIG. 3 is a diagram of a phase encoding method according to an embodiment of this application. The method may specifically include the following steps.

S301: Generate all first-order terms and higher-order terms based on a quantity of bits needed for encoding.

The method may be applied to a communication device. The communication device may include a base station, an RIS, a router, and the like. In other words, the communication device may encode a phase by using the method. Before encoding, the quantity of bits needed for encoding may be first determined. The quantity of bits may be determined based on a quantity of to-be-encoded phases.

In an example, if the quantity of to-be-encoded phases is 2*^{N}*, the quantity of bits needed for encoding the phases is *N.* In other words, in the phase encoding method provided in this embodiment of this application, *N* bits may be used to encode 2*^{N}* to-be-encoded target phases. The 2*^{N}* to-be-encoded target phases may be marked with a vector P=[Ø₁, ..., Ø_{2*_{N}*}].

After the quantity of bits needed for encoding is determined, all first-order terms and higher-order terms of the *N* bits may be first generated.

The first-order terms of the *N* bits may be the *N* bits.

For example, if the *N* bits are respectively *s*₁, *s*₂, ..., and *s_{N},* all the first-order terms are *s*₁, *s*₂, ... , and *s_{N}.*

The higher-order terms of the *N* bits may include all higher-order terms including a second-order product term to an *N*-order product term. A higher-order term of any order may include product terms of a plurality of bits, and bits in a same product term need to be different from each other.

For example, if the *N* bits are respectively *s*₁, *s*₂, ... , and *s_{N},* second-order terms of the *N* bits may include *sᵢsⱼ*(*i* ≠ *j*). For example, *s*₁*s*₂, *s*₁*s*₃, *s*₁*s*₄, ..., *s*₁*s_{N}, s*₂*s*₃, *s*₂*s*₄, ..., *s*₂*s_{N},* ..., and *s*_{*N-*1}*s_{N}* are included. A total quantity of second-order terms is ${C}_{N}^{2}$*.*

Third-order terms may include *sᵢsⱼsₖ*(*i* ≠ *j* ≠ *k).* For example, *s*₁*s*₂*s*₃, *s*₁*s*₂*s*₄, *s*₁*s*₂*s*₅ , ..., *s*₁*s*₂*s_{N}, s*₂*s*₃*s*₄, *s*₂*s*₃*s*₅, ..,*s*₂*s*₃*s_{N}*, ..., and *s*_{*N-*2}*s*_{*N*-1}*s_{N}* are included. A total quantity of third-order terms is ${C}_{N}^{3}$*.*

Similarly, an *N*-order term may include *s*₁*s*₂ ... *s_{N},* and a quantity of *N*-order terms is 1, that is, ${C}_{N}^{N}$*.*

Therefore, when a quantity of the plurality of bits is *N* and an order is *X,* a quantity of higher-order terms with the order is ${C}_{N}^{X}$*.*

A total quantity of all the first-order terms and higher-order terms of the *N* bits is 2*^{N}.*

S302: Construct a bit matrix based on all the first-order terms and higher-order terms.

After all the first-order terms and higher-order terms of the *N* bits are generated, the bit matrix may be constructed. The bit matrix may include a plurality of value combinations of the plurality of bits.

In a possible implementation, all the first-order terms and higher-order terms may be combined, and 2*^{N}* coefficients c are used to construct a system of linear equations, and the bit matrix is determined based on the system of linear equations.

The constructed system of linear equations in this embodiment of this application may include a plurality of equations, and a quantity of the plurality of equations is equal to the quantity of to-be-encoded phases. For example, if the quantity of to-be-encoded phases is 2*^{N}*, the constructed system of linear equations includes 2*^{N}* equations.

For example, the system of linear equations including 2*^{N}* equations may be represented as follows: $\left\{\begin{matrix}{\sum }_{i = 1}^{N} {c}_{i} {s}_{i} + {\sum }_{i , j = 1 , j > i}^{N} {c}_{ij} {s}_{i} {s}_{j} + … + {c}_{{2}^{N}} {s}_{1} {s}_{2} … {s}_{N} = {∅}_{1} \left({s}_{1}=…={s}_{N}=1\right) \\ {\sum }_{i = 1}^{N} {c}_{i} {s}_{i} + {\sum }_{i , j = 1 , j > i}^{N} {c}_{ij} {s}_{i} {s}_{j} + … + {c}_{{2}^{N}} {s}_{1} {s}_{2} … {s}_{N} = {∅}_{{2}^{N}} \left({s}_{1}=…={s}_{N}=-1\right)\end{matrix}\right.$

It can be seen from Formula (2) that expressions of to-be-encoded phases on one side of equal signs of the plurality of equations are different from each other, in other words, an expression of one phase is on the right side of the equal signs of the equations of the system of linear equations, that is, Ø₁ to Ø_{2_{N}}. Expressions of all the first-order terms and higher-order terms of the plurality of bits on the other side of the equal signs of the plurality of equations are the same, and are all ${\sum }_{i = 1}^{N} {c}_{i} {s}_{i} + {\sum }_{i , j = 1 , j > i}^{N} {c}_{ij} {s}_{i} {s}_{j} + ⋯ + {c}_{{2}^{N}} {s}_{1} {s}_{2} … {s}_{N}$. These first-order terms and higher-order terms further have coefficients respectively, that is, *c*₁, ..., and *c*₂*_{N},* and all coefficients form an encoding coefficient used for subsequent encoding.

In this embodiment of this application, the bit matrix *S_{N}* may be constructed by using a total of combinations of the *N* bits, and a value of the matrix may include the plurality of value combinations of the plurality of bits. The value combinations of the *N* bits form a row [*s*₁, *s*₂, ... , *s*₁*s*₂ ...*s_{N}*] of the bit matrix. Correspondingly, each column of the bit matrix corresponds to values of higher-order terms or first-order terms of the *N* bits.

Because each column of the bit matrix is linearly independent, the finally obtained bit matrix is a full-rank square matrix.

S303: Perform a matrix operation on the bit matrix to obtain the encoding coefficient.

Formula (2) in the previous step may be expressed in a matrix calculation form, that is, the following Formula (3): ${S}_{N} {C}^{T} = {P}^{T}$

*S_{N}* is the bit matrix, a vector C=[*c*₁, ... , *c*_{2*_{N}*}], the vector C is a coefficient vector including a plurality of encoding coefficients, a vector P is a phase vector including the plurality of to-be-encoded phases, and *C^{T}* and *P^{T}* are respectively transposes of the coefficient vector C and the phase vector P.

Formula (3) is processed to obtain an expression of the encoding coefficient as follows: ${C}^{T} = {{S}_{N}}^{- 1} {P}^{T}$

*S_{N}*⁻¹ is an inverse matrix of the bit matrix *S_{N}*.

S304: Perform phase encoding by using the encoding coefficient.

The to-be-encoded phases may be encoded by using the calculated encoding coefficient. Specifically, the calculated encoding coefficient may be substituted into the system of linear equations (2), to complete encoding of the phases.

In this embodiment of this application, the higher-order term is introduced to construct encoding, so that a coefficient matrix of a system of linear equations that needs to be solved is a full-rank square matrix, and one-to-one encoding on *N* bits to 2*^{N}* phases is implemented. In the method, a large quantity of redundant codes are not generated in an encoding process. This is beneficial to optimization of a subsequent optimization algorithm. In addition, in the phase encoding method provided in this embodiment of this application, a quantity of bits needed for encoding can be reduced as much as possible. In comparison with conventional technologies in which only phase encoding is performed through QAM, the quantity of bits can be halved.

For ease of understanding, the following describes the phase encoding method provided in this embodiment of this application with reference to a specific example.

FIG. 4 is a diagram of phases of an antenna element according to an embodiment of this application. There are eight to-be-encoded phases shown in FIG. 4, to be specific, any marked point in *A*₀, ... , and *A*₇ in FIG. 4 represents a to-be-encoded phase. It can be seen from FIG. 4 that rotation angles of the phases are equally spaced.

If rotation angles of a plurality of to-be-encoded phases are equally spaced, a half of the phases may be obtained by rotating the other half of the phases by 180°, that is, the other half of the phases may be obtained by multiplying the half of the phases by -1. For example, the phase *A*₄ may be obtained by rotating the phase *A*₀ in FIG. 4 by 180°. Therefore, when the rotation angles of the plurality of phases are equally spaced, a simplified calculation method may be used in a process of generating higher-order terms, and only higher-order terms of odd-numbered terms are extracted.

The following describes the phase encoding method in this embodiment of this application by using an example in which eight phases in FIG. 4 are encoded.

Because a quantity of to-be-encoded phases is 8, that is, 2³ phases, a quantity of bits needed for encoding is 3. In other words, a process of encoding eight phases using three bits is described in this example. With reference to FIG. 4, the eight to-be-encoded phases may be represented as Ø=*e^{jθ}*, where an angle θ may be represented as: $θ = \frac{2 iπ}{8} \left(i=0,…,7\right)$

According to the encoding process described in the foregoing embodiment, all first-order terms and higher-order terms of three bits need to be first generated. In this example, only higher-order terms of odd-numbered terms need to be extracted, and only all first-order terms and third-order terms need to be used during actual encoding. The third-order terms may be represented as *s*₁*s*₃*s*₃.

Then, the bit matrix *S_{N}* is constructed. According to the encoding process described in the foregoing embodiment, a constructed linear equation may be expressed as: $∅ = {c}_{1} {s}_{1} + {c}_{2} {s}_{2} + {c}_{3} {s}_{3} + {c}_{4} {s}_{1} {s}_{2} {s}_{3}$

There are eight combinations of bit values in total. Because a half of the phases in FIG. 4 may be obtained by multiplying the other half of the phases by -1, and only all odd-numbered product terms are taken in this process, only a half of the 2*^{N}* general systems of equations described in the foregoing embodiment are linearly independent. In this case, a value of one bit may be fixed to generate the bit matrix *S_{N}*.

For example, assuming *s*₁=1, a corresponding bit matrix may be obtained as follows: ${S}_{N} = \left[\begin{matrix}1 & 1 & 1 & 1 \\ 1 & 1 & - 1 & - 1 \\ 1 & - 1 & 1 & - 1 \\ 1 & - 1 & - 1 & 1\end{matrix}\right]$

It is clear that, *s*₁ may alternatively be another value, for example, *s*₁=-1, and the obtained bit matrix may be represented as: ${S}_{N} = \left[\begin{matrix}- 1 & 1 & 1 & - 1 \\ - 1 & 1 & - 1 & 1 \\ - 1 & - 1 & 1 & 1 \\ - 1 & - 1 & - 1 & - 1\end{matrix}\right]$

For the angle θ, angle values obtained when *i*=0,1,2,3 are extracted, that is, the following angle values are extracted: $\left[0, \frac{π}{4}, \frac{π}{2}, \frac{3 π}{4}\right]$

In this way, the phase vector *P* may be generated as follows: $P = \left[1,{e}^{j \frac{π}{4}},1j,{e}^{j \frac{3 π}{4}}\right]$

According to Formula (4), the coefficient vector used for encoding may be calculated as follows: ${C}^{T} = \left[\begin{matrix}{c}_{1} \\ {c}_{2} \\ {c}_{3} \\ {c}_{4}\end{matrix}\right] = \frac{1}{4} \left[\begin{matrix}1 + \left(\sqrt{2}-1\right) j \\ 1 - \left(\sqrt{2}+1\right) j \\ \left(1+\sqrt{2}\right) + 1 j \\ \left(1-\sqrt{2}\right) + 1 j\end{matrix}\right]$

A result of Formula (11) is substituted into the equation (6), and the phase encoding process is completed.

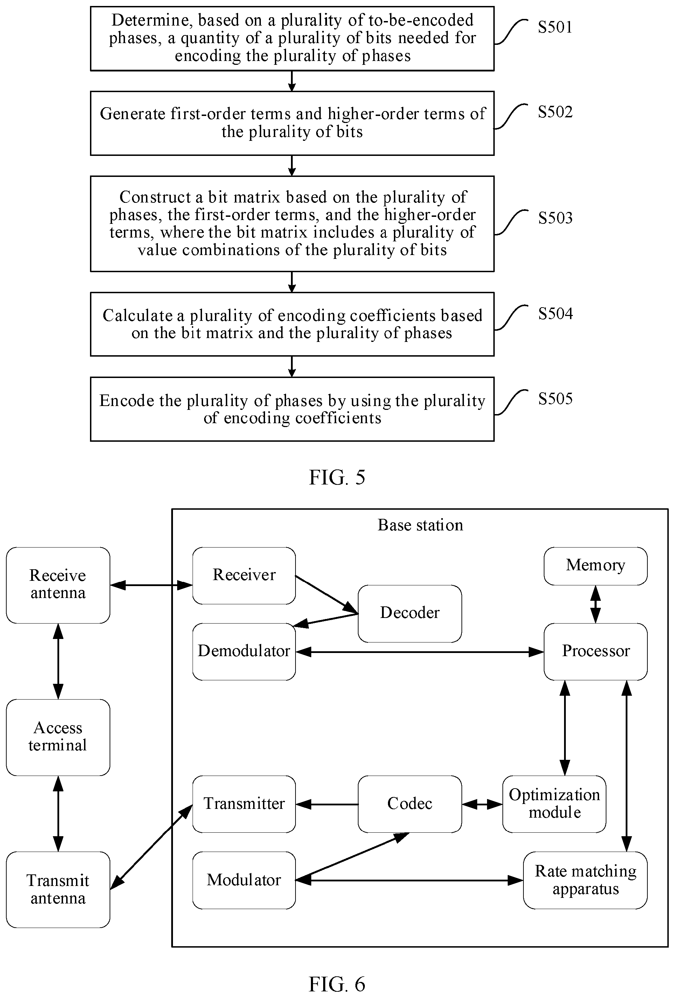

With reference to the foregoing embodiments, FIG. 5 is a schematic flowchart of a phase encoding method according to an embodiment of this application. The method may specifically include the following steps.

S501: Determine, based on a plurality of to-be-encoded phases, a quantity of a plurality of bits needed for encoding the plurality of phases.

The method may be applied to a communication device. In other words, this embodiment of this application may be executed by the communication device. For example, the communication device may include devices such as a base station, an RIS, and a router. A specific type of the communication device is not limited in this embodiment of this application.

A quantity of the plurality of to-be-encoded phases may be determined based on an actual communication requirement. Generally, the quantity of the plurality of to-be-encoded phases may be 2 to the power of *N,* that is, 2*^{N}.* The 2*^{N}* to-be-encoded target phases may be marked with a vector P=[Ø₁ ..., Ø_{2*_{N}*}].

In this embodiment of this application, when the quantity of to-be-encoded phases is 2*^{N},* the quantity of bits needed for encoding the 2*^{N}* phases is *N.* The *N* bits may be represented as *s*₁, *s*₂, ... , and *s_{N}.*

S502: Generate first-order terms and higher-order terms of the plurality of bits.

In this embodiment of this application, the first-order terms and the higher-order terms of the plurality of bits may be separately generated. The first-order term of each bit may be the bit. For example, if the *N* bits are respectively *s*₁, *s*₂, ..., and *s_{N},* all first-order terms are *s*₁, *s*₂, ... , and *s_{N}.*

For the higher-order terms, all higher-order terms including a second-order product term to an *N*-order product term may be obtained by multiplying the bits one by one. A higher-order term of any order may include product terms of the plurality of bits, and bits in a same product term are different from each other.

For example, for the *N* bits *s*₁, *s*₂, ... , and *s_{N}* in the foregoing example, second-order terms of the *N* bits may include ${C}_{N}^{2}$ *sᵢsⱼ*(*i* ≠ j), third-order terms may include ${C}_{N}^{3}$ *sᵢsⱼsₖ*(*i* ≠ *j* ≠ *k*), and *N*-order terms may include ${C}_{N}^{N}$ *s*₁*s*₂ ...*s_{N}.*

During specific implementation, an order of a to-be-generated higher-order term may be first determined, and then a quantity of higher-order terms with the order is determined, so that all higher-order terms of a corresponding order may be obtained by multiplying the bits one by one based on the quantity of terms.

S503: Construct a bit matrix based on the plurality of phases, the first-order terms, and the higher-order terms, where the bit matrix includes a plurality of value combinations of the plurality of bits.

The bit matrix in this embodiment of this application may be the bit matrix *S_{N}* in the foregoing embodiments. A system of linear equations may be constructed based on the plurality of to-be-encoded phases and all first-order terms and higher-order terms of the plurality of bits, and then the bit matrix *S_{N}* is determined based on the system of linear equations.

In this embodiment of this application, a quantity of equations included in the system of linear equations is equal to the quantity of the plurality of phases, expressions of to-be-encoded phases on one side of equal signs of the plurality of equations are different from each other, expressions of all the first-order terms and higher-order terms of the plurality of bits on the other side of the equal signs of the plurality of equations are the same, the first-order term and the higher-order term in each equation have coefficients respectively, and all coefficients form an encoding coefficient used for subsequent encoding.

In a possible implementation of this embodiment of this application, if rotation angles of the plurality of to-be-encoded phases are equally spaced, a half of the phases may be obtained by rotating the other half of the phases by 180°, that is, the other half of the phases may be obtained by multiplying the half of the phases by -1. Therefore, if the rotation angles of the plurality of to-be-encoded phases are equally spaced, when the higher-order terms are actually generated, the higher-order terms of odd-numbered terms may be extracted, and then the system of linear equations is constructed based on the plurality of to-be-encoded phases and all the first-order terms and the higher-order terms of the odd-numbered terms of the plurality of bits, to simplify a calculation process.

In this embodiment of this application, when the bit matrix is determined based on the system of linear equations, a value of any bit may be first determined, and then values of other bits are generated based on the value of the any bit, to obtain the plurality of value combinations of the plurality of bits. The plurality of value combinations of the plurality of bits jointly form the bit matrix.

In a possible implementation of this embodiment of this application, the values of the any bit and the other bits may be 1 or -1.

S504: Calculate a plurality of encoding coefficients based on the bit matrix and the plurality of phases.

In this embodiment of this application, to calculate the encoding coefficients, a phase vector including the plurality of to-be-encoded phases may be first determined. For example, the phase vector may be represented as a vector P= [Ø₁, ... , Ø_{2*_{N}*}]. Then, a product, that is, *S_{N}*⁻¹*P^{T},* of a transpose *P^{T}* of the phase vector *P* and an inverse matrix *S_{N}*⁻¹ of the bit matrix *S_{N}* is calculated, to obtain a transpose of a coefficient vector including the plurality of encoding coefficients. For example, if a vector C=[*c*₁, ... , *c*_{2*_{N}*}] is used to represent the coefficient vector, an expression of *C^{T}*=*S_{N}*⁻¹*P^{T}* exists. The plurality of encoding coefficients may be determined based on the transpose *C^{T}* of the coefficient vector.

S505: Encode the plurality of phases by using the plurality of encoding coefficients.

The to-be-encoded phase may be encoded by using the calculated encoding coefficients.

The phase encoding method provided in this embodiment of this application may be applied to a plurality of communication scenarios. For example, in each communication device that needs to perform beamforming, phase encoding may be performed by using the method. For example, in a beamforming process of the base station, the intelligent reflecting surface, or the router, the method may be used for encoding. Alternatively, in any communication scenario, if a signal is a discrete value, the method may also be used for encoding. Alternatively, in any other scenario including but not limited to a communication scenario, if a discrete value needs to be encoded, the method may also be used for encoding. For example, in any scenario, if an object that needs to be encoded is a discrete value, the method may also be used for encoding. In other words, the phase encoding method provided in this embodiment of this application may be applied to not only a communication scenario, but also a non-communication scenario, and not only a phase may be encoded, but also another discrete encoding object may be encoded.

FIG. 6 is a diagram of a system architecture of a base station according to an embodiment of this application. The phase encoding method provided in this embodiment of this application may be applied to the system architecture of the base station shown in FIG. 6 to perform phase encoding. Compared with a conventional base station, in the base station shown in FIG. 6, a codec is added between a transmitter that transmits a signal and a modulator that modulates the signal, and an encoding function of the codec may be used to complete phase encoding. The codec may further calculate bits used for completing phase encoding, decode, by using a decoding function, calculated bit spin distribution into a phase, and then apply the phase to a transmit signal. Correspondingly, in consideration of a requirement for future dynamic beamforming optimization, a decoder may be introduced at a receive end of the base station to obtain an initial value of bit spin distribution, to quickly track a target user subsequently to perform beamforming.

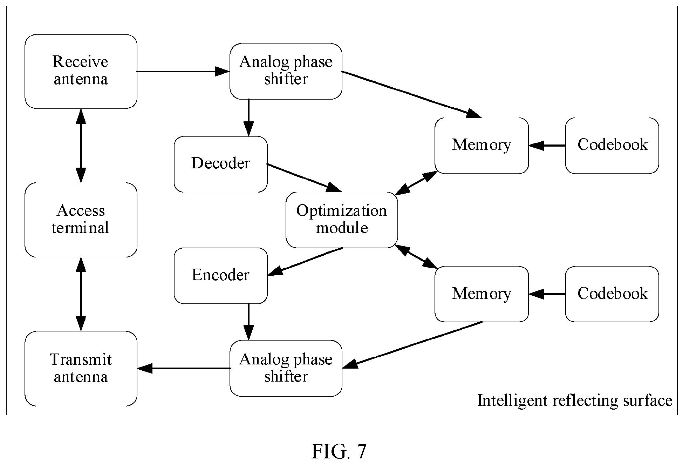

FIG. 7 is a diagram of a system architecture of an RIS according to an embodiment of this application. The phase encoding method provided in this embodiment of this application may also be applied to the system architecture of the RIS shown in FIG. 7 to perform phase encoding. Specifically, on the basis of original codebook optimization of the RIS, an encoder, a decoder, and a corresponding optimization module are introduced at a receive end and a transmit end of the RIS shown in FIG. 7, and fast and accurate beamforming is implemented by enhancing dynamic optimization of a transmit surface phase.

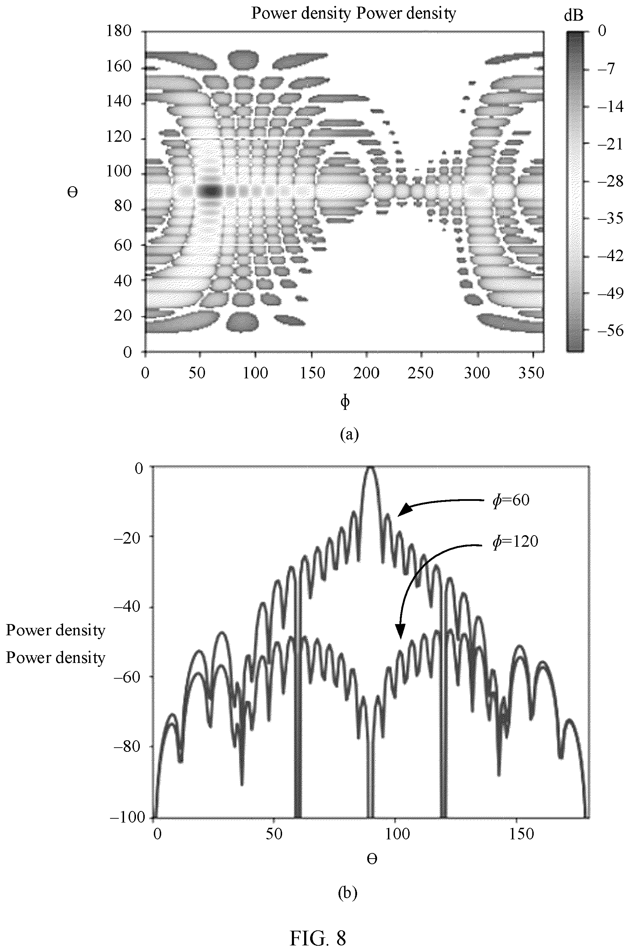

The phase encoding method provided in this embodiment of this application is used for encoding, so that a good effect can be achieved in a subsequent beamforming task. FIG. 8 is a diagram of a beamforming result according to an embodiment of this application. FIG. 8 shows a unidirectional beamforming optimization result calculated by using a quantum heuristic algorithm after a phase is encoded by using the method. (a) in FIG. 8 shows distribution of space electromagnetic field energy in a control direction angle, where θ and ϕ are three-dimensional space angles, θ is an included angle between a radiation direction and a z axis, and a target forming direction in (a) in FIG. 8 is θ=90°, and ϕ=60°. On the basis of (a) in FIG. 8, (b) in FIG. 8 shows a slice graph in a direction of ϕ=60° and ϕ=120°. It can be seen from FIG. 8 that a good forming effect in a target direction can be achieved by using the method for encoding.

In addition, the phase encoding method provided in this embodiment of this application is combined with the quantum heuristic algorithm, so that it takes only several seconds to complete weight optimization of a thousand-level array scale. Table 1 shows time needed for optimizing quantities of elements of four different array scales and quantities of bits of single-antenna elements.

**Table 1**

| Array scale | 240 array elements (m=24, n=10); sn=3 | 1024 array elements (m=64, n=32); sn=3 | 240 array elements (m=24, n=10); sn=4 | 1024 array elements (m=64, n=32); sn=4 |
|---|---|---|---|---|
| Optimization time t | 2s | 20s | 10s | 40s |

m and n respectively represent a quantity of elements in a vertical direction and a quantity of elements in a horizontal direction, sn represents the quantity of bits of the single-antenna element, and a unit of the optimization time t is second (s).

In embodiments of this application, functional modules of a communication device may be obtained through division based on the foregoing method examples. For example, each functional module may be obtained through division based on each corresponding function, or one or more functions may be integrated into one functional module. The integrated module may be implemented in a form of hardware, or may be implemented in a form of a software functional module. It should be noted that, in embodiments of this application, module division is an example, and is merely a logical function division. In actual implementation, another division manner may be used. An example in which each functional module is obtained through division based on each corresponding function is used below for description.

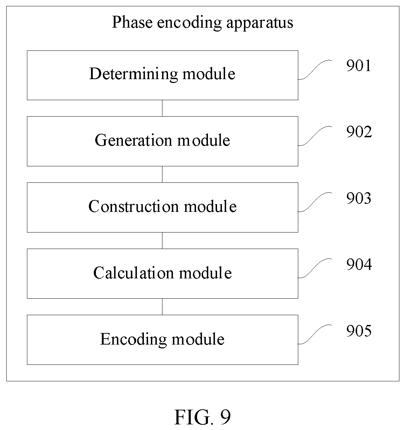

Corresponding to the foregoing embodiments, FIG. 9 is a block diagram of a structure of a phase encoding apparatus according to an embodiment of this application. The apparatus may be used in the communication device in the foregoing embodiments. The apparatus may specifically include the following modules: a determining module 901, a generation module 902, a construction module 903, a calculation module 904, and an encoding module 905.

The determining module 901 is configured to determine, based on a plurality of to-be-encoded phases, a quantity of a plurality of bits needed for encoding the plurality of phases.

The generation module 902 is configured to generate first-order terms and higher-order terms of the plurality of bits.

The construction module 903 is configured to construct a bit matrix based on the plurality of phases, the first-order terms, and the higher-order terms, where the bit matrix includes a plurality of value combinations of the plurality of bits.

The calculation module 904 is configured to calculate a plurality of encoding coefficients based on the bit matrix and the plurality of phases.

The encoding module 905 encodes the plurality of phases by using the plurality of encoding coefficients.

In a possible implementation of this embodiment of this application, when a quantity of the plurality of phases is 2*^{N},* the quantity of bits needed for encoding the 2*^{N}* phases is *N.*

In a possible implementation of this embodiment of this application, the generation module 902 may be specifically configured to:
generate a first-order term of each bit, where the first-order term may be the bit; and
multiply the bits one by one to obtain the higher-order terms including a second-order product term to an N-order product term, where N is a quantity of the plurality of bits, a higher-order term of any order may include product terms of the plurality of bits, and bits in a same product term are different from each other.

In this embodiment of this application, the generation module 902 may be further configured to: determine an order of a to-be-generated higher-order term; determine a quantity of higher-order terms with the order; and multiply the bits one by one based on the quantity of terms to obtain the higher-order terms with the order.

In this embodiment of this application, when a quantity of the plurality of bits is *N* and the order is *X,* the quantity of higher-order terms with the order is ${C}_{N}^{X}$.

In a possible implementation of this embodiment of this application, the construction module 903 may be specifically configured to: construct a system of linear equations based on the plurality of phases, the first-order terms, and the higher-order terms; and determine the bit matrix based on the system of linear equations.

A quantity of equations included in the system of linear equations is equal to the quantity of the plurality of phases, expressions of the phases on one side of equal signs of the plurality of equations are different from each other, expressions of the first-order terms and the higher-order terms on the other side of the equal signs of the plurality of equations are the same, the first-order term and the higher-order term in each equation have coefficients respectively, and the coefficients form the encoding coefficients.

In this embodiment of this application, the construction module 903 may be further configured to: if rotation angles of the plurality of phases are equally spaced, extract the higher-order terms of odd-numbered terms; and construct the system of linear equations based on the plurality of phases, the first-order terms, and the higher-order terms of the odd-numbered terms.

In this embodiment of this application, the construction module 903 may be further configured to: determine a value of any bit; and generate values of other bits based on the value of the any bit, to obtain the plurality of value combinations of the plurality of bits, where the plurality of value combinations form the bit matrix.

In a possible implementation of this embodiment of this application, the values of the any bit and the other bits are 1 or -1.

In a possible implementation of this embodiment of this application, the calculation module 904 may be specifically configured to: determine a phase vector including the plurality of phases; calculate a product of a transpose of the phase vector and an inverse matrix of the bit matrix, to obtain a transpose of a coefficient vector including the plurality of encoding coefficients; and determine the plurality of encoding coefficients based on the transpose of the coefficient vector.

It should be noted that all related content of the steps in the foregoing method embodiments may be cited in function description of corresponding functional modules. Details are not described herein again.

An embodiment of this application further provides a chip. The chip includes a processor. The processor may be a general purpose processor, or may be a dedicated processor. The processor is configured to support a communication device in performing the foregoing related steps, to implement the phase encoding method in the foregoing embodiments.

Optionally, the chip further includes a transceiver. The transceiver is configured to receive control from the processor, and is configured to support the communication device in performing the foregoing related steps, to implement the phase encoding method in the foregoing embodiments.

Optionally, the chip may further include a storage medium.

It should be noted that the chip may be implemented by using the following circuits or components: one or more field programmable gate arrays (field programmable gate arrays, FPGAs), a programmable logic device (programmable logic device, PLD), a controller, a state machine, gate logic, a discrete hardware component, any other suitable circuit, or any combination of circuits capable of performing various functions described throughout this application.

## Claims

1. A phase encoding method, comprising:
determining, based on a plurality of to-be-encoded phases, a quantity of a plurality of bits needed for encoding the plurality of phases;
generating first-order terms and higher-order terms of the plurality of bits;
constructing a bit matrix based on the plurality of phases, the first-order terms, and the higher-order terms, wherein the bit matrix comprises a plurality of value combinations of the plurality of bits;
calculating a plurality of encoding coefficients based on the bit matrix and the plurality of phases; and
encoding the plurality of phases by using the plurality of encoding coefficients.

2. The method according to claim 1, wherein determining, based on the plurality of to-be-encoded phases, the quantity of the plurality of bits needed for encoding the plurality of phases comprises:
when a quantity of the plurality of phases is 2*^{N}*, determining that the quantity of bits needed for encoding the 2*^{N}* phases is *N.*

3. The method according to claim 1, wherein generating the first-order terms and the higher-order terms of the plurality of bits comprises:
generating a first-order term of each bit, wherein the first-order term is the bit; and
multiplying the bits one by one to obtain the higher-order terms comprising a second-order product term to an N-order product term, wherein *N* is the quantity of the plurality of bits, a higher-order term of any order comprises product terms of the plurality of bits, and bits in a same product term are different from each other.

4. The method according to claim 3, wherein multiplying the bits one by one to obtain the higher-order terms comprising the second-order product term to the N-order product term comprises:
determining an order of a to-be-generated higher-order term;
determining a quantity of higher-order terms with the order; and
multiplying the bits one by one based on the quantity of terms to obtain the higher-order terms with the order.

5. The method according to claim 4, wherein determining the quantity of higher-order terms with the order comprises:
when the quantity of the plurality of bits is *N* and the order is *X,* determining that the quantity of higher-order terms with the order is ${C}_{N}^{X}$.

6. The method according to any one of claims 1 to 5, wherein constructing the bit matrix based on the plurality of phases, the first-order terms, and the higher-order terms comprises:
constructing a system of linear equations based on the plurality of phases, the first-order terms, and the higher-order terms; and
determining the bit matrix based on the system of linear equations, wherein
a quantity of equations comprised in the system of linear equations is equal to the quantity of the plurality of phases, expressions of the phases on one side of equal signs of the plurality of equations are different from each other, expressions of the first-order terms and the higher-order terms on the other side of the equal signs of the plurality of equations are the same, the first-order term and the higher-order term in each equation have coefficients respectively, and the coefficients form the encoding coefficients.

7. The method according to claim 6, wherein constructing the system of linear equations based on the plurality of phases, the first-order terms, and the higher-order terms comprises:
if rotation angles of the plurality of phases are equally spaced, extracting the higher-order terms of odd-numbered orders; and
constructing the system of linear equations based on the plurality of phases, the first-order terms, and the higher-order terms of the odd-numbered orders.

8. The method according to claim 6, wherein determining the bit matrix based on the system of linear equations comprises:
determining a value of any bit; and
generating values of other bits based on the value of the any bit, to obtain the plurality of value combinations of the plurality of bits, wherein the plurality of value combinations form the bit matrix.

9. The method according to claim 8, wherein the values of the any bit and the other bits are 1 or -1.

10. The method according to any one of claims 1 to 5 or 7 to 9, wherein calculating the plurality of encoding coefficients based on the bit matrix and the plurality of phases comprises:
determining a phase vector comprising the plurality of phases;
calculating a product of a transpose of the phase vector and an inverse matrix of the bit matrix, to obtain a transpose of a coefficient vector comprising the plurality of encoding coefficients; and
determining the plurality of encoding coefficients based on the transpose of the coefficient vector.

11. A communication device, comprising a memory, a processor, and a computer program that is stored in the memory and that is executable on the processor, wherein when executing the computer program, the processor implements the phase encoding method according to any one of claims 1 to 10.

12. The communication device according to claim 11, wherein the communication device comprises any one of a base station, an intelligent reflecting surface, or a router.

## Patentansprüche

1. Phasencodierungsverfahren, das umfasst:
Bestimmen, basierend auf einer Vielzahl von zu codierenden Phasen, einer Menge einer Vielzahl von Bits, die zum Codieren der Vielzahl von Phasen erforderlich sind;
Erzeugen von Termen erster Ordnung und Termen höherer Ordnung der Vielzahl von Bits;
Erstellen einer Bitmatrix basierend auf der Vielzahl von Phasen, den Termen erster Ordnung und den Termen höherer Ordnung, wobei die Bitmatrix eine Vielzahl von Wertkombinationen der Vielzahl von Bits umfasst;
Berechnen einer Vielzahl von Codierungskoeffizienten basierend auf der Bitmatrix und der Vielzahl von Phasen und
Codieren der Vielzahl von Phasen durch Verwenden der Vielzahl von Codierungskoeffizienten.

2. Verfahren nach Anspruch 1, wobei das Bestimmen, basierend auf der Vielzahl von zu codierenden Phasen, der Menge der Vielzahl von Bits, die zum Codieren der Vielzahl von Phasen erforderlich sind, umfasst:
wenn eine Menge der Vielzahl von Phasen 2*^{N}* ist, Bestimmen, dass die Menge von Bits, die zum Codieren der 2*^{N}* Phasen erforderlich ist, *N* ist.

3. Verfahren nach Anspruch 1, wobei das Erzeugen der Terme erster Ordnung und der Terme höherer Ordnung der Vielzahl von Bits umfasst:
Erzeugen eines Terms erster Ordnung jedes Bits, wobei der Term erster Ordnung das Bit ist; und
Multiplizieren der Bits der Reihe nach, um die Terme höherer Ordnung, umfassend einen Produktterm zweiter Ordnung bis zu einem Produktterm *N*-ter Ordnung, zu erhalten, wobei *N* die Menge der Vielzahl von Bits ist, ein Term höherer Ordnung einer beliebigen Ordnung Produktterme der Vielzahl von Bits umfasst und Bits in einem gleichen Produktterm voneinander verschieden sind.

4. Verfahren nach Anspruch 3, wobei das Multiplizieren der Bits der Reihe nach, um die Terme höherer Ordnung, umfassend den Produktterm zweiter Ordnung bis zum Produktterm *N*-ter Ordnung zu erhalten, umfasst:
Bestimmen einer Ordnung eines zu erzeugenden Terms höherer Ordnung;
Bestimmen einer Menge von Termen höherer Ordnung mit der Ordnung und
Multiplizieren der Bits der Reihe nach basierend auf der Menge von Termen, um die Terme höherer Ordnung mit der Ordnung zu erhalten.

5. Verfahren nach Anspruch 4, wobei das Bestimmen der Menge von Termen höherer Ordnung mit der Ordnung umfasst:
wenn die Menge der Vielzahl von Bits *N* ist und die Ordnung *X* ist, Bestimmen, dass die Menge von Termen höherer Ordnung mit der Ordnung ${C}_{N}^{X}$ ist.

6. Verfahren nach einem der Ansprüche 1 bis 5, wobei das Erstellen der Bitmatrix basierend auf der Vielzahl von Phasen, der Terme erster Ordnung und der Terme höherer Ordnung umfasst:
Erstellen eines Systems linearer Gleichungen basierend auf der Vielzahl von Phasen, den Termen erster Ordnung und den Termen höherer Ordnung und
Bestimmen der Bitmatrix basierend auf dem System linearer Gleichungen, wobei eine Menge von Gleichungen, die im System linearer Gleichungen enthalten ist, gleich der Menge der Vielzahl von Phasen ist, Ausdrücke der Phasen auf einer Seite von Gleichheitszeichen der Vielzahl von Gleichungen voneinander verschieden sind, Ausdrücke der Terme erster Ordnung und der Terme höherer Ordnung auf der anderen Seite der Gleichheitszeichen der Vielzahl von Gleichungen gleich sind, der Term erster Ordnung und der Term höherer Ordnung in jeder Gleichung jeweils Koeffizienten aufweisen und die Koeffizienten die Codierungskoeffizienten bilden.

7. Verfahren nach Anspruch 6, wobei das Erstellen des Systems linearer Gleichungen basierend auf der Vielzahl von Phasen, den Termen erster Ordnung und den Termen höherer Ordnung umfasst:
wenn Drehwinkel der Vielzahl von Phasen gleich beabstandet sind, Extrahieren der Terme höherer Ordnung ungeradzahliger Ordnungen; und
Erstellen des Systems linearer Gleichungen basierend auf der Vielzahl von Phasen, den Termen erster Ordnung und den Termen höherer Ordnung der ungeradzahligen Ordnungen.

8. Verfahren nach Anspruch 6, wobei das Bestimmen der Bitmatrix basierend auf dem System linearer Gleichungen umfasst:
Bestimmen eines Werts eines beliebigen Bits und
Erzeugen von Werten anderer Bits basierend auf dem Wert des beliebigen Bits, um die Vielzahl von Wertkombinationen der Vielzahl von Bits zu erhalten, wobei die Vielzahl von Wertkombinationen die Bitmatrix bilden.

9. Verfahren nach Anspruch 8, wobei die Werte des beliebigen Bits und der anderen Bits 1 oder -1 sind.

10. Verfahren nach einem der Ansprüche 1 bis 5 oder 7 bis 9, wobei das Berechnen der Vielzahl von Codierungskoeffizienten basierend auf der Bitmatrix und der Vielzahl von Phasen umfasst:
Bestimmen eines Phasenvektors, umfassend die Vielzahl von Phasen;
Berechnen eines Produkts einer Transponierten des Phasenvektors und einer inversen Matrix der Bitmatrix, um eine Transponierte eines Koeffizientenvektors, umfassend die Vielzahl von Codierungskoeffizienten, zu erhalten; und
Bestimmen der Vielzahl von Codierungskoeffizienten basierend auf der Transponierten des Koeffizientenvektors.

11. Kommunikationsgerät, umfassend einen Speicher, einen Prozessor und ein Computerprogramm, das im Speicher gespeichert ist und das auf dem Prozessor ausführbar ist, wobei, wenn das Computerprogramm ausgeführt wird, der Prozessor das Phasencodierungsverfahren nach einem der Ansprüche 1 bis 10 implementiert.

12. Kommunikationsgerät nach Anspruch 11, wobei das Kommunikationsgerät ein beliebiges von einer Basisstation, einer intelligenten reflektierenden Oberfläche oder einem Router umfasst.

## Revendications

1. Procédé de codage de phase, comprenant les étapes consistant à :
déterminer, sur la base d'une pluralité de phases à coder, une quantité d'une pluralité de bits nécessaires pour coder la pluralité de phases ;
générer des termes de premier ordre et des termes d'ordre supérieur de la pluralité de bits ;
construire une matrice de bits sur la base de la pluralité de phases, des termes de premier ordre et des termes d'ordre supérieur, la matrice de bits comprenant une pluralité de combinaisons de valeurs de la pluralité de bits ;
calculer une pluralité de coefficients de codage sur la base de la matrice de bits et de la pluralité de phases ; et
coder la pluralité de phases en utilisant la pluralité de coefficients de codage.

2. Procédé selon la revendication 1, dans lequel la détermination, sur la base de la pluralité de phases à coder, de la quantité de la pluralité de bits nécessaires pour coder la pluralité de phases consiste à :
lorsqu'une quantité de la pluralité de phases est 2*^{N}*, déterminer que la quantité de bits nécessaires pour coder les 2*^{N}* phases est *N*.

3. Procédé selon la revendication 1, dans lequel la génération des termes de premier ordre et des termes d'ordre supérieur de la pluralité de bits consiste à :
générer un terme de premier ordre de chaque bit, le terme de premier ordre étant le bit ; et
multiplier les bits un par un pour obtenir les termes d'ordre supérieur comprenant un terme de produit de deuxième ordre jusqu'à un terme de produit d'ordre *N*, *N* étant la quantité de la pluralité de bits, un terme d'ordre supérieur de n'importe quel ordre comprenant des termes de produit de la pluralité de bits, et les bits d'un même terme de produit étant différents les uns des autres.

4. Procédé selon la revendication 3, dans lequel la multiplication des bits un par un pour obtenir les termes d'ordre supérieur comprenant le terme de produit de deuxième ordre jusqu'à un terme de produit d'ordre *N* consiste à :
déterminer un ordre d'un terme d'ordre supérieur à générer ;
déterminer une quantité de termes d'ordre supérieur avec l'ordre ; et
multiplier les bits un par un sur la base de la quantité de termes pour obtenir les termes d'ordre supérieur avec l'ordre.

5. Procédé selon la revendication 4, dans lequel la détermination de la quantité de termes d'ordre supérieur avec l'ordre consiste à :
lorsque la quantité de la pluralité de bits est *N* et que l'ordre est *X*, déterminer que la quantité de termes d'ordre supérieur avec l'ordre est ${C}_{N}^{X}$.

6. Procédé selon l'une quelconque des revendications 1 à 5, dans lequel la construction de la matrice de bits sur la base de la pluralité de phases, des termes de premier ordre et des termes d'ordre supérieur consiste à :
construire un système d'équations linéaires sur la base de la pluralité de phases, des termes de premier ordre et des termes d'ordre supérieur ; et
déterminer la matrice de bits sur la base du système d'équations linéaires,
une quantité d'équations comprises dans le système d'équations linéaires étant égale à la quantité de la pluralité de phases, les expressions des phases sur un côté de signes égaux de la pluralité d'équations étant différentes les unes des autres, les expressions des termes de premier ordre et des termes d'ordre supérieur sur l'autre côté des signes égaux de la pluralité d'équations étant identiques, le terme de premier ordre et le terme d'ordre supérieur dans chaque équation ayant respectivement des coefficients, et les coefficients formant les coefficients de codage.

7. Procédé selon la revendication 6, dans lequel la construction du système d'équations linéaires sur la base de la pluralité de phases, des termes de premier ordre et des termes d'ordre supérieur consiste à :
si les angles de rotation de la pluralité de phases sont espacés régulièrement, extraire les termes d'ordre supérieur des ordres de numéro impair ; et
construire le système d'équations linéaires sur la base de la pluralité de phases, des termes de premier ordre et des termes d'ordre supérieur des ordres de numéro impair.

8. Procédé selon la revendication 6, dans lequel la détermination de la matrice de bits sur la base du système d'équations linéaires consiste à :
déterminer une valeur de n'importe quel bit ; et
générer les valeurs des autres bits sur la base de la valeur dudit n'importe quel bit, afin d'obtenir la pluralité de combinaisons de valeurs de la pluralité de bits, la pluralité de combinaisons de valeurs formant la matrice de bits.

9. Procédé selon la revendication 8, dans lequel les valeurs dudit n'importe quel bit et des autres bits sont 1 ou -1.

10. Procédé selon l'une quelconque des revendications 1 à 5 ou 7 à 9, dans lequel le calcul de la pluralité de coefficients de codage sur la base de la matrice de bits et de la pluralité de phases consiste à :
déterminer un vecteur de phases comprenant la pluralité de phases ;
calculer un produit d'une transposée du vecteur de phases et d'une matrice inverse de la matrice de bits, afin d'obtenir une transposée d'un vecteur de coefficients comprenant la pluralité de coefficients de codage ; et
déterminer la pluralité de coefficients de codage sur la base de la transposée du vecteur de coefficients.

11. Dispositif de communication, comprenant une mémoire, un processeur et un programme informatique qui est stocké dans la mémoire et qui peut être exécuté par le processeur, de telle sorte que lorsque le processeur exécute le programme informatique, il met en œuvre le procédé de codage de phase selon l'une quelconque des revendications 1 à 10.

12. Dispositif de communication selon la revendication 11, le dispositif de communication comprenant un élément quelconque parmi une station de base, une surface à réflexion intelligente, ou un routeur.
